# EUROPEAN PATENT APPLICATION

(11) **EP 2 437 290 A1**
(43) Date of publication of application: **04.04.2012**
(21) Application number: 11007881.3
(22) Date of filing: 29.09.2011
(51) Int. Cl.: H01L 21/677, B65G 49/06, B65G 51/03

(54) **Workpiece transport method and workpiece transport apparatus**

(30) Priority: 01.10.2010 JP 2010223426
(71) Applicant: Nitto Denko Corporation, Osaka 567-8680 (JP)
(72) Inventor: Yamamoto, Masayuki, Ibaraki-shi Osaka 567-8680 (JP); Hase, Yukitoshi, Ibaraki-shi Osaka 567-8680 (JP)
(74) Representative: Hauck Patent- und Rechtsanwälte

(57) **Abstract**

A wafer floats and is transported while gas is blown from holes passing vertically through a middle portion of a transport path against a rear face of the wafer to be transported, and from holes on opposite sides of the transport path that are inclined obliquely relative to a traveling direction of the wafer toward a center axis of the transport path against the rear face of the wafer. In the step of transporting the wafer, a flow rate of gas is adjusted that is blown from the holes on a side where the wafer deviates from a transport course.

## Description

### BACKGROUND OF THE INVENTION

(1) Field of the Invention

This invention relates to a method and apparatus for transporting various types of workpieces, such as a semiconductor wafer and a circuit board, in a non-contact manner.

(2) Description of the Related Art

Such as apparatus for transporting a semiconductor wafer (hereinafter, simply referred to as a "wafer") in a non-contact manner has been suggested and implemented as workpiece transport apparatus. Specifically, the wafer is loaded and unloaded to and from a wafer cassette through air float, the wafer cassette having semiconductor wafers housed therein in a stack manner at a given pitch in a height direction. That is, an air float table is provided under the wafer cassette having a notch cut out rearward from a front face in a rectangular shape. When a wafer is unloaded from the wafer cassette, the air float table blows air against a rear face of the wafer exposed from the wafer cassette for floating the wafer. Simultaneously, the wafer is moved forward to a position immediately under a vacuum suction plate that is in a standby state above the air float table. The vacuum suction plate suction-holds a surface of the wafer in a position of receiving the wafer, whereby the wafer is unloaded from the wafer cassette.

When the wafer is loaded from the wafer cassette, the wafer having the surface suction-held by the vacuum suction plate is transported above the air float table. At this time, the air float table blows air against a rear face of the wafer to float the wafer. Simultaneously, the wafer is loaded into the wafer cassette while the vacuum suction plate releases suction-holding of the wafer and retracts. See Japanese Patent Publication No. H04-25153.

In the foregoing exemplary apparatus, the wafer is floated and transported with use of the air float table only within a portion of only several centimeters of an aperture in the cassette. Consequently, the wafer is effectively unloaded and loaded from and into the wafer cassette in a non-contact manner. However, where the wafer is transported over a long distance with use of the air float table, a problem may arise that the wafer floating in a non-contact manner serpentines, thereby falling from the air float table and being damaged.

Here, providing guide walls on opposite sides of the air float table along a transportation direction may prevent the wafer from falling from the air float table. Another problem may arise, however, that the wafer moving above the air float table serpentines to come into collision with the guide walls, which leads to damages in an outer edge of the wafer.

### SUMMARY OF THE INVENTION

This invention has been made regarding the state of the art noted above, and its primary object is to provide a workpiece transport method and workpiece transport apparatus that allows accurate transport of a workpiece, such as a semiconductor wafer and a circuit board, in a non-contact manner.

This invention discloses a method of transporting a workpiece including the steps of transporting the workpiece and controlling a course of the workpiece. In the step of transporting the workpiece, the workpiece is transported forward while floating by blowing air vertically against a rear face of the workpiece from a first blow-off section provided in a middle portion of a transport surface of a transport path having a large width than the workpiece. In the step of controlling the course of the workpiece, the course of the workpiece is controlled while a flow rate of gas is adjusted that is blown obliquely against the rear face of the workpiece toward a center axis of the transport path from second blow-off sections provided on opposite sides of the transport surface of the transport path in a width direction.

According to this method of transporting the workpiece, when the workpiece floats above the transport surface of the transport path and serpentines, the flow rate of gas that is blown from the second blow-off sections is controlled for suppression of serpentine movement of the workpiece. Consequently, the workpiece may be transported accurately along a given transport course while being prevented from falling out of the transport course and from collision with the guide walls.

In the foregoing method, in the step of controlling the course, detectors of a non-contact type that arc spaced away at a given clearance in the width direction of the workpiece detect an end of the workpiece. The second blow-off section on one side where the end of the workpiece has been detected blows a more flow rate of gas than that on the other side for controlling the course of the workpiece. Such configuration is preferable.

According to this method, the second blow-off section on one side where the end of the workpiece has been detected blows a more flow rate of gas against the rear face of the workpiece than that on the other side. Consequently, the workpiece tending to deviate from a prescribed transport course may be returned back to the transport course. Accordingly, the foregoing apparatus may suitably be performed.

In the foregoing method, a nozzle blows gas from rearward of the workpiece in the transportation direction to float the workpiece that is held on a holding table, and forward force is applied to move the workpiece above the transport surface of the transport path. In the transportation step, the transport path is inclined obliquely downward relative to the transport course to apply forward force to the workpiece for transportation of the workpiece, and the transport surface of the transport path is returned to its horizontal attitude to stop transportation of the workpiece. Such configuration is preferable.

According to this method, gas is blown against the workpiece from rearward thereof. Thus, the workpiece floats with negative pressure. The floating workpiece may be transported toward the transport path. The workpiece reaching above the transport surface is transported while forward force is applied thereto along the transport path that is inclined obliquely downward, and stops through returning of the transport path to its horizontal attitude. Consequently, the workpiece may be transported in a non-contact state from transportation to stop thereof.

In addition, in the foregoing method, support pins push upward and support the rear face of the workpiece held on the holding table for allowing the nozzle to blow gas against the rear face of the workpiece from rearward thereof. Such configuration is preferable.

According to this method, the workpiece may be transported above the transport path while reliably floating from the holding table.

The second blow-off sections may blow gas obliquely relative to a traveling direction of the workpiece toward the center axis of the transport path.

According to this method, force to move the workpiece forward may be obtained without inclining the transport path obliquely downward.

This invention also discloses workpiece transport apparatus for transporting a workpiece. The apparatus includes a workpiece transport section, a gas supply unit, a workpiece carrying mechanism, detectors, and a controller. The workpiece transport section has a transport surface of a transport path including a first blow-off section and second blow-off sections, the first blow-off section blowing gas vertically from a center portion thereof to a rear face of the workpiece along a transportation direction of the workpiece, the second blow-off sections blowing gas obliquely toward a center axis of the transport path along a workpiece width direction. The workpiece transport section transports the workpiece through floating thereof above the transport surface of the transport path having a given clearance in the workpiece width direction and a larger size than the workpiece. The gas supply unit supplies gas towards the first blow-off section and the second blow-off sections provided in the transport surface. The workpiece carrying mechanism carries the workpiece towards the workpiece transport section. The detectors detect an end of the workpiece transported by the workpiece transport section. The controller controls a course of the workpiece through making a more flow rate of gas from the second blow-off section on one side where the detector detects the end of the workpiece as compared to that from the second blow-off section on the other side.

According to this configuration, the flow rate of gas from the second blow-off section on one side where the detector detects the end of the workpiece is more than that from the second blow-off section on the other side. Consequently, the workpiece tending to deviate from the workpiece transport course may be returned back to a center of the transport path. Accordingly, the foregoing method may suitably be performed.

In the foregoing configuration, the workpiece transport mechanism may be composed of a holding table for holding the workpiece and a nozzle for blowing gas from rearward of the workpiece held on the holding table.

According to this configuration, the workpiece may be transported toward the workpiece transport section while floating due to pressure difference between the rear face of the workpiece and a holding surface of the holding table that is generated from gas blown from rearward of the workpiece.

Moreover, the foregoing configuration may include two or more support pins for supporting the workpiece through pushing upward the rear face of the workpiece.

It is easier to float the workpiece with this configuration as compared to floating of the workpiece held on the holding table, allowing transportation of the workpiece to the workpiece transport section.

Moreover, the foregoing configuration includes a swinging section provided with at least the workpiece transport section, and a drive mechanism. The swinging section allows swinging about a front end thereof as a supporting point that is on a starting position side of transporting the workpiece. The drive mechanism drives the swinging section. The controller also controls the drive mechanism as to transport the workpiece through swinging the workpiece transport section downward in transporting the workpiece while the workpiece floats, and as to stop the workpiece in a given position through swinging the workpiece transport section upward in accordance with reaching of the workpiece in the given position. Such configuration may be adopted.

According to this configuration, the workpiece may be processed in a non-contact manner during transportation of the workpiece to the given position.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

Figure 1 is a plan view of workpiece transportation apparatus.

Figure 2 is a front view of the workpiece transportation apparatus.

Figure 3 is an explanatory operation view of a holding table.

Figure 4 is a sectional view of a transport path.

Figure 5 is a plan view of the holding table.

Figures 6 to 9 are views each showing operations of the exemplary apparatus.

Figure 10 is a plan view of apparatus according to one modification.

Figure 11 is a sectional view of a transport path in the apparatus according to the modification.

### DESCRIPTION OF THE PREFERRED EMBODIMENTS

One embodiment of this invention is now to be described below with reference to the drawings.

Here, in this exemplary apparatus, a semiconductor wafer (hereinafter, appropriately referred to as a "wafer") will be described as one example of a workpiece to be transported. For instance, back reinforcement is performed to the wafer via a double-faced adhesive tape with a support substrate, such as a stainless steel or a glass substrate, in the same shape as the wafer. Alternatively, back grinding is performed to the rear face of the wafer with a surface-protective adhesive tape joined thereto. Thereafter, the support substrate and the double-faced adhesive tape, or the surface protective adhesive tape is removed from the surface of the wafer. Such wafer is adopted. Here, the workpiece is not limited in particular in type and shape. For instance, various substrates, such as a circuit board and a glass substrate, may be adopted as a workpiece. The shape thereof may be circular or rectangular.

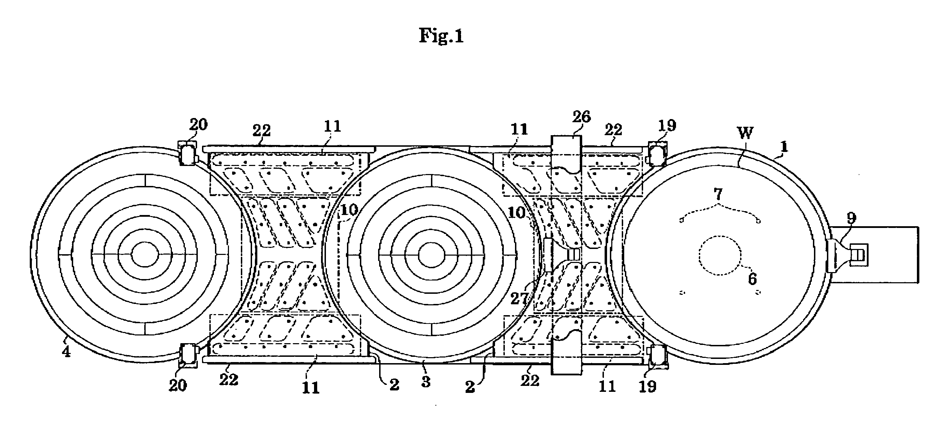

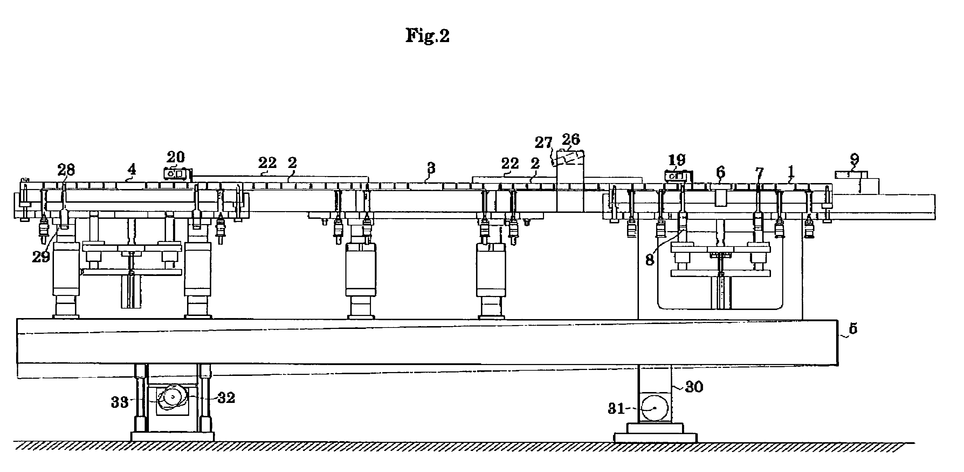

Figure 1 is a plan view showing workpiece transportation apparatus according to this invention. Figure 2 is a front view thereof.

As shown in Figures 1 and 2, the workpiece transportation apparatus includes a holding table 1, a transport path 2, a cooling stage 3, a transportation stage 4 that are positioned on a swinging movable board 5 via a support frame. Next, each component will be described in detail.

The holding table 1 is a metal chuck table. The chuck table is in communication with an external vacuum device via a channel. That is, the chuck table suction-holds a wafer W placed on the holding table 1. The holding table 1 is provided with a suction pad 6 and two or more support pins 7. Here, the holding table 1 is not limited to metal, but may be formed of a ceramic porous material.

The suction pad 6 is placed at a center portion of the holding table 1, and its top surface movable upward and downward is formed as a vacuum suction surface.

The support pins 7 are spaced at regular intervals on a given circumference of the holding table 1. Specifically, the support pins 7 are movable upward and downward from a holding surface of the holding table 1 via cylinders 8. Moreover, a tip of the support pin 7 is formed of an insulator, or is covered with an insulator.

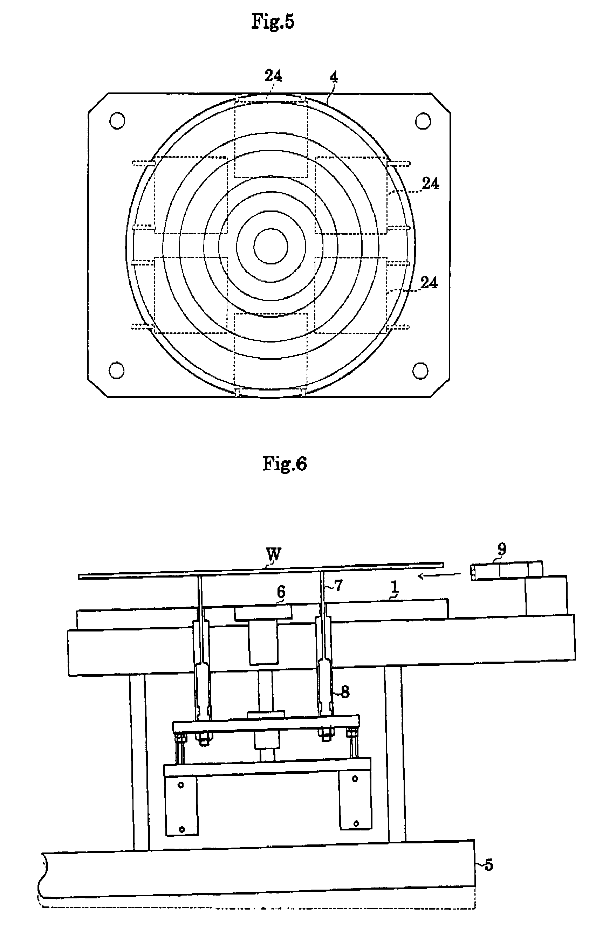

A nozzle 9 is arranged behind the holding table 1. As shown in Figure 6, the nozzle 9 blows air between the holding table 1 and the wafer W pushed upward from the holding table 1 and held by the support pins 7.

Now referring again to Figure 1. Two transport paths 2 are provided each having a plate-like shape with a width larger than the wafer W to be transported. Specifically, one transport path 2 is connected to the cooling stage 3 and the holding table 1. The other transport path 2 is connected to the holding table 1 and the transportation stage 4. The transport path 2 has a transport surface including a first blow-off section 10 and second blow-off sections 11. The first blow-off section 10 is shown in Figure 1 by alternate long and short dash lines at a center portion of the transport path 2 along a transportation direction. The second blow-off sections 11 are shown in Figure 1 by alternate long and short dash lines on opposite sides of the transport path 2 as to sandwich the first blow-off section 10.

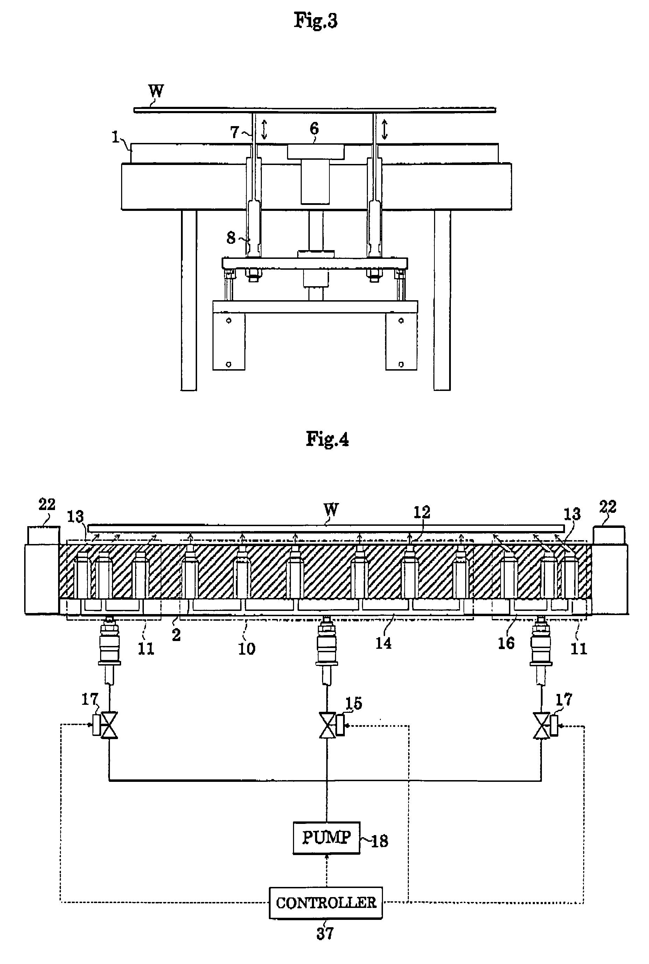

As shown in Figure 4, the first blow-off section 10 includes two or more holes 12 formed vertically through the transport path 2. The holes 12 are brought together by a channel 14 formed in a rear face of the transport path 2. The channel 14 where the holes 12 are brought together into one is provided with a first magnetic valve 15. The first magnetic valve 15 is in communication with a pump 18.

The second blow-off section 11 has two or more holes 13 formed through the transport path 2 obliquely toward a center thereof relative to a traveling direction of the wafer W. The holes 13 are each brought together by a channel 16 at every second blow-off section 11 on a rear face side on opposite ends of the transport path 2. Each channel 16 where the holes 13 are brought together into one is provided with a second magnetic valve 17. The second magnetic valves 17 are in communication with the pump 18.

Now referring again to Figures 1 and 2. Two detectors each consisting of a light projector 19 and a light receiver 20 are positioned on opposite ends of the transport path 2 in a width direction. The light projector 19 is on a transport start position side of the transport path 2, the light receiver 20 on a transport termination position side. That is, each detector is spaced away by a given clearance in the width direction of the transport path 2 from an outer periphery end of the wafer W that is transported along the center of the transport path 2.

Moreover, guide walls 22 are each provided on opposite ends of the transport path 2 for preventing the wafer W from dropping. The surface of the guide wall 22 is covered with an elastic body.

The cooling stage 3 is a metal chuck table. The cooling stage includes a temperature sensor. Moreover, the cooling stage includes inside thereof a Peltier device 24 for cooling the wafer W on the stage, as shown by chain dashes in Figure 5. Moreover, as shown in Figures 1 and 2, a nozzle 27 is provided in a support frame erected on a side face of the transport path 2 in front of the cooling stage 3.

The nozzle 27 has a front end directed obliquely downward to blow air toward a back end of the wafer W on the cooling stage 3.

The transportation stage 4 is a metal chuck table. The chuck table is in communication with an external vacuum device via a channel. That is, the chuck table is configured as to suction-hold the wafer W that is transported from the transportation stage 4. Moreover, the transportation stage 4 is provided with support pins 28 similarly to the holding table 1. Here, the transportation stage 4 is not limited to metal, but may be formed of a ceramic porous material.

The support pins 28 are spaced away at given intervals on a given circumference of the transportation stage 4. The support pins 28 are movable upward/downward from the holding surface of the transportation stage 4 via cylinders 29. Moreover, a tip end of the support pin 28 is formed of an insulator, or is covered with an insulator.

The swinging movable board 5 is swingingly supported via a support shaft 31 in a strut 30 provided on a lower side of the holding table 1. The swinging movable board 5 is supported via a lifting cam 32 on a lower side of the transportation stage 4. Specifically, the lifting cam 32 is driven backward and forward by a motor 33 connected thereto. Accordingly, the swinging movable board 5 is inclined obliquely downward at minute angles in the traveling direction of the wafer W while pivoting about the support shaft 31.

Description will be given next of basic operation for transporting the wafer W from the holding table 1 to the transportation stage 4 with use of the apparatus in the foregoing exemplary embodiment.

Firstly, the wafer W having the rear face suction-held by a U-shaped tip arm of a transport robot, not shown, is transported onto the holding table 1.

The wafer W on the holding table 1 is once received on the suction pad 6 projecting from the holding table 1. Thereafter, the wafer W is placed on the upper surface of the holding table 1 in a given attitude and position as the suction pad 6 moves downward.

Then, the support pins 7 moves upward and project from the holding table 1 to push the wafer W upward from the holding table 1, as shown in Figure 3. The cam 32 rotates forward under this state. Accordingly, the holding table 1 is inclined obliquely downward in the transport direction, as shown in Figure 6, as the swinging movable table 5 swings downward in the transport direction. Simultaneously, the wafer W floats from the support pins 7 while the nozzle 9 blows air from rearward against the wafer W, and then the support pins 7 move downward. Consequently, the wafer W floats above the holding table 1, and moves toward the transport path 2 through forward force.

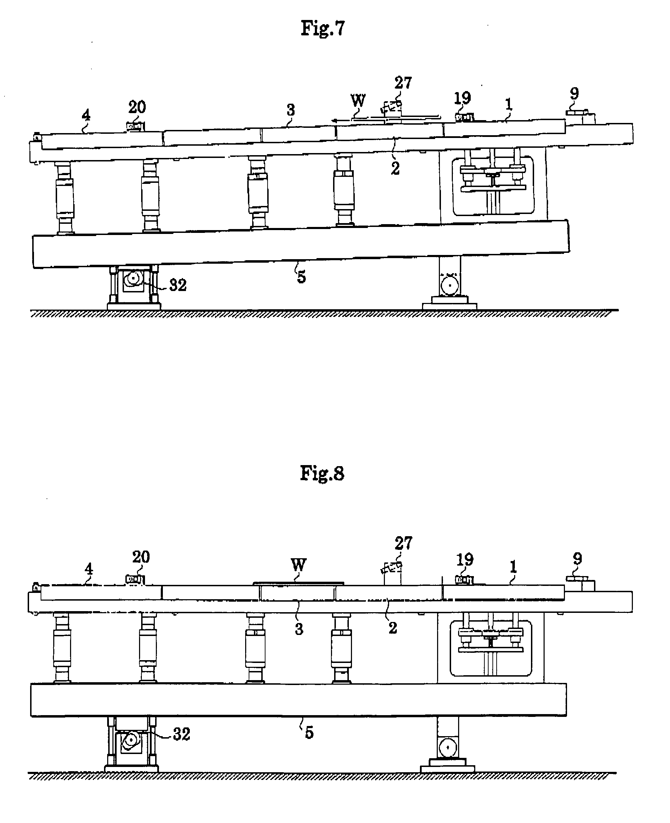

As shown in Figures 4 and 7, a uniform flow rate of gas is blown from the holes 12 and 13 of the first and second blow-off sections 10 and 11, respectively, provided on the surface of the transport path 2. The wafer W is transported above the transport path toward the cooling stage 3.

As shown in Figure 8, the swinging movable table 5 returns to its horizontal attitude through backward rotation of the cam 32 before the wafer W reaches on the cooling stage 3. Then, the wafer W is placed on the cooling stage 3. Here, timing of returning the swinging movable board 5 horizontally is determined, for example, in accordance with the result that a sensor, not shown, detects passing of the wafer W through a given position or for a given time of period.

A temperature sensor monitors temperatures of the wafer W while the wafer W is cooled on the cooling stage 3 for a given time of period. Upon reaching a given temperature of the wafer W, the cam 32 rotates forward to swing the swinging movable board 5 downward, and the nozzle 27 blows gas from rearward against the wafer W. Here, the wafer W floats due to a Bernoulli effect generated from pressure difference between the holding surface of the cooling stage 3 and the rear face of the wafer W. In addition, forward force is applied to the wafer W. Accordingly, the wafer W is transported to the transport stage 4 while floating above the transport path 2 where gas is blown.

The swinging movable table 5 returns to its horizontal attitude through backward rotation of the cam 32 before the wafer W reaches on the transport stage 4. Then, the wafer W is placed on the transport stage 4. Here, timing of returning the swinging movable board 5 horizontally is determined, for example, in accordance with the result that a sensor, not shown, detects passing of the wafer W through a given position or for a given time of period.

The wafer W on the transport stage 4 is pushed upward and supported via the support pins 28. The wafer W having the rear face suction-held by a transport robot, not shown, is transported from the transport stage 4 similarly to carrying onto the holding table 1.

Thus, a round of operation is completed as mentioned above. The similar operation is to be repeated hereinafter.

Next, description will be given of controlling transportation of the wafer W above the transport path 2.

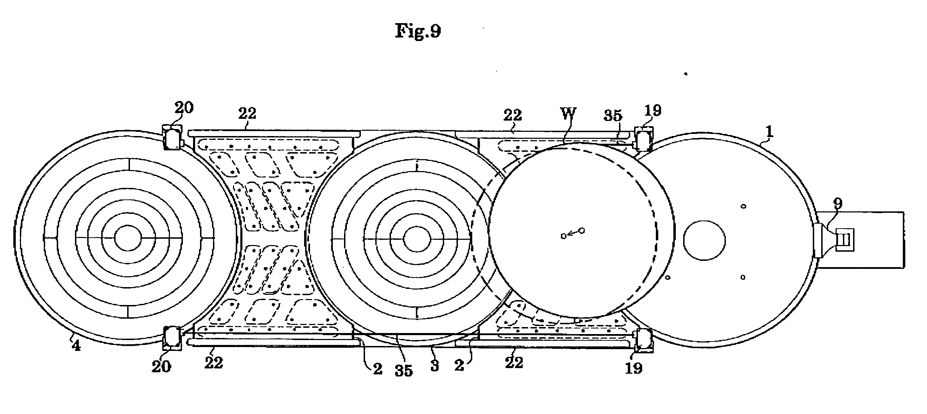

The wafer W may deviate outwardly from a regular course on the transport path 2 due to deformation or deviation in weight balance of the wafer W, etc., during transportation of the wafer W from the holding table 1 or the cooling stage 3 over the transport path 2. Here, as shown in Figure 9, light beams 35 from one projector 19 is intercepted, and signals from the light receiver 20 is turned off. A controller 37 controls the degree of opening of the second magnetic valve 17 in the channel 16 in communication with the holes 13 of the second blow-off section 11 in an off state such that the second blow-off section 11 blows a more flow rate of gas than the first blow-off section 10.

The time for blowing increased gas is set as appropriate in accordance with type, shape, and weight of the wafer W. That is, setting of a relationship between a flow rate and time varies appropriately through reproducibility testing or a simulation. Moreover, a condition where the wafer W returns to a regular course at the center of the transport path 2 is determined in advance.

The second blow-off section 11 blows an increased flow rate of gas obliquely toward the center of the transport path 2 in the wafer traveling direction for a given time of period. The center of the wafer W deviating from a central axis of the transport path 2 returns to the center of the transport path 2, which is as shown by two-point chain dashes. The wafer W is then transported to the stages 3 and 4 along the transport path 2 under this state.

According to the foregoing exemplary apparatus, the detector detects the wafer W floating from the holding table 1 above the transport path 2 to the stages 3 and 4 when the wafer W deviates from the regular course on the transport path 2. Control is made of the flow rate of gas from the second blow-off section 11 as well a blowing time of gas. Consequently, the wafer W may be returned to the regular course at the center of the transport path 2. In other words, the wafer W may be transported accurately to each stage while floating over the transport path 2 in a non-contact manner without collision with the guide walls 22 on opposite sides of the transport path 2.

This invention may be embodied as the following aspects.

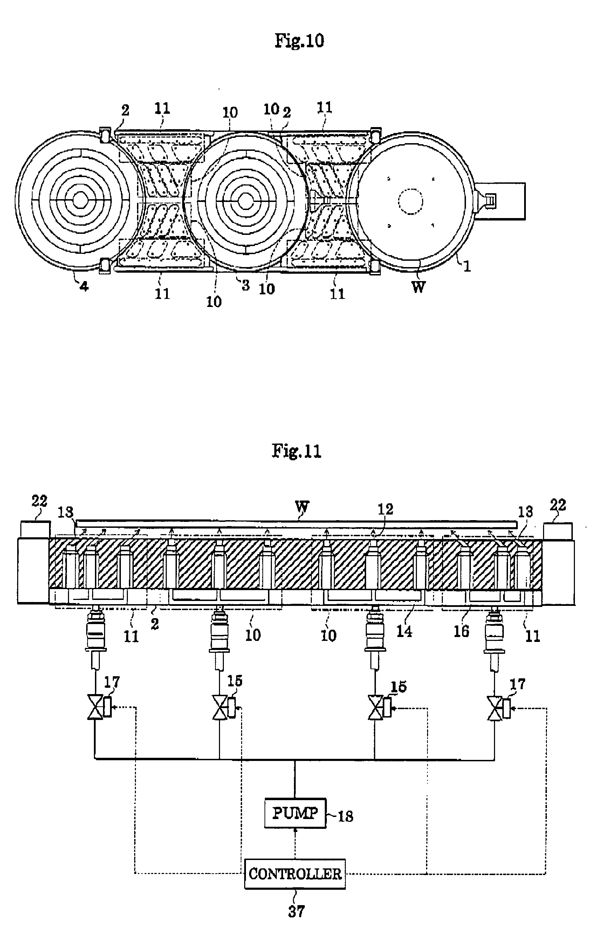

The first blow-off section 10 of the foregoing exemplary apparatus may be divided into two portions on both sides along an axis of the transport path 2 as shown in Figure 10 by alternate long and short dash lines. In this embodiment shown in Figure 11, the two portions of the first blow-off section 10 and the two portions of the second blow-off section 11 each include the first and second magnetic valves 15 and 17, respectively, provided in one channel into which the holes 12 and 13 are brought together for controlling the flow rate and blowing times of gas from the blow-off sections. This configuration may realize more accurate correction of the course of the wafer W.

The second blow-off section 11 in the foregoing exemplary apparatus may have the holes 13 that are formed as to pass through the transport surface inclined obliquely toward the center thereof. That is, in the case where sufficient forward force is applied to the wafer W through blowing gas from the nozzle 9 and inclination of the swinging movable table 5, this configuration may realize transportation of the wafer W to each stage.

In the foregoing exemplary embodiment, an actuator such as a cylinder moves the lower side of the holding table 1 upward to swing the swinging movable table 5 downward in the transportation direction. Such configuration may be adopted.

In the foregoing exemplary apparatus, the holding table 1 may include no support pin 7. Specifically, the wafer W may float with the nozzle 9 through pressure difference generated between the holding surface of the holding table and the rear face of the wafer W, which is similar to the cooling stage 3.

In the foregoing exemplary apparatus, the detector is not limited to an optical sensor consisting of the light projector 19 and the light receiver 20, but may be an optical camera.

It will be apparent to those skilled in the art that various modifications and variations can be made in the present invention without departing from the spirit or scope of the invention Thus, it is intended that the present invention cover the modifications and variations of this invention provided they come within the scope of the appended claims and their equivalents.

## Claims

1. A method of transporting a workpiece, comprising the steps of:
transporting the workpiece while floating by blowing air vertically against a rear face of the workpiece from a first blow-off section provided in a middle portion of a transport surface of a transport path having a large width than the workpiece; and
controlling a course of the workpiece while a flow rate of gas is adjusted that is blown obliquely against the rear face of the workpiece toward a center axis of the transport path from second blow-off sections provided on opposite sides of the transport surface of the transport path in a width direction.

2. The method of transporting the workpiece according to claim 1, wherein
in the step of controlling the course, detectors of a non-contact type that are spaced away at a given clearance in the width direction of the workpiece detect an end of the workpiece, and the second blow-off section on one side where the end of the workpiece has been detected blows a more flow rate of gas than that on the other side for controlling the course of the workpiece.

3. The method of transporting the workpiece according to claim 1, wherein
a nozzle blows gas from rearward of the workpiece in the transportation direction to float the workpiece that is held on a holding table, and forward force is applied to move the workpiece above the transport surface of the transport path, and
in the transportation step, the transport path is inclined obliquely downward relative to the transport course to apply forward force to the workpiece for transportation of the workpiece, and the transport surface of the transport path is returned to its horizontal attitude to stop transportation of the workpiece.

4. The method of transporting the workpiece according to claim 3, wherein
support pins push upward and support the rear face of the workpiece held on the holding table for allowing the nozzle to blow gas against the rear face of the workpiece from rearward thereof.

5. The method of transporting the workpiece according to claim 1, wherein
the second blow-off sections blow gas obliquely relative to a traveling direction of the workpiece toward the center axis of the transport path.

6. Workpiece transport apparatus for transporting a workpiece, comprising:
a workpiece transport section having a transport surface of a transport path, including a first blow-off section and second blow-off sections, for transporting the workpiece through floating thereof above the transport surface of the transport path having a given clearance in the workpiece width direction and a larger size than the workpiece, the first blow-off section blowing gas vertically from a center portion thereof to a rear face of the workpiece along a transportation direction of the workpiece, the second blow-off sections blowing gas obliquely toward a center axis of the transport path along a workpiece width direction;
a gas supply unit for supplying gas towards the first blow-off section and the second blow-off sections provided in the transport surface;
a workpiece carrying mechanism for carrying the workpiece towards the workpiece transport section;
detectors for detecting an end of the workpiece transported by the workpiece transport section; and
a controller for controlling a course of the workpiece through making a more flow rate of gas from the second blow-off section on one side where the detector detects the end of the workpiece as compared to that from the second blow-off section on the other side.

7. The workpiece transport apparatus according to claim 6, wherein
the workpiece transport mechanism is composed of a holding table for holding the workpiece and a nozzle for blowing gas from rearward of the workpiece held on the holding table.

8. The workpiece transport apparatus according to claim 7, wherein
the holding table includes two or more support pins for supporting the workpiece through pushing upward the rear face of the workpiece.

9. The workpiece transport apparatus according to claim 6, further comprising:
a swinging section provided with at least the workpiece transport section that allows swinging about a front end thereof as a supporting point that is on a starting position side of transporting the workpiece; and
a drive mechanism for driving the swinging section, wherein
the controller also controls the drive mechanism as to transport the workpiece through swinging the workpiece transport section downward in transporting the workpiece while the workpiece floats, and as to stop the workpiece in a given position through swinging the workpiece transport section upward in accordance with reaching of the workpiece in the given position.
